Europäisches Patentamt

European Patent Office

Office européen des brevets

(11) Publication number: **0 130 468**
**B1**

# EUROPEAN PATENT SPECIFICATION

(45) Date of publication of patent specification: 19.04.89

(51) Int. Cl.[4]: **H 05 K 3/28**

(21) Application number: 84107040.2

(22) Date of filing: 20.06.84

(54) Protective coatings for conductors to prevent mechanical and electronic failures particularly during heat-treatment of their supporting structures.

(30) Priority: 30.06.83 US 509742

(43) Date of publication of application:
09.01.85 Bulletin 85/02

(45) Publication of the grant of the patent:
19.04.89 Bulletin 89/16

(84) Designated Contracting States:
DE FR GB

(56) References cited:
GB-A-2 073 778
US-A-3 073 762
US-A-3 202 590

JOURNAL OF APPLIED PHYSICS, vol. 50, no. 4, April 1979, pages 2713,2714, American Institute of Physics, New York, US; G.C. CHI et al.: "Structural characterization of amorphous electrodeposited cobalt-phosphorus alloys"

(73) Proprietor: International Business Machines Corporation
Old Orchard Road
Armonk, N.Y. 10504 (US)

(72) Inventor: Acosta, Raul Edmundo
115 Ogden Avenue
White Plains New York 10605 (US)
Inventor: Horkans, Wilma Jean
38 1/2 Wolden Road
Ossining New York 10562 (US)
Inventor: Mukherjee, Ruby
7143 Anjou Creek Circle
San Jose California 95120 (US)
Inventor: Olsen, Judith Diane
Box 130-6B Boulder Lane
Goldens Bridge New York 10526 (US)

(74) Representative: Blake, John
IBM United Kingdom Limited
Intellectual Property Department
Hursley Park Winchester
Hampshire SO21 2JN (GB)

Courier Press, Leamington Spa, England.

## Description

This invention relates to protective coatings for conductors to prevent mechanical and electronic failures particularly during heat-treatment of their supporting structures. The invention has significant utility in the protection of Cu current-carrying lines in electronic structures that comprise multi layers that are subjected to heat treatments that would normally adversely affect the Cu lines.

Current-carrying lines are often fabricated from materials such as copper and its alloys, which are readily corrosible in different atmospheres. In particular, packages of microelectronic circuitry commonly comprise a substrate, at least one layer of copper current-carrying lines, at least one layer of an organic dielectric material (such as polyimide) which serves as an insulator, and additional layers of current-carrying lines. These structures have to be heat-treated in order to cure the organic dielectric. During the curing cycles these organic materials often release water as a by-product. Also, even after these organic dielectrics are cured, they remain permeable to water and to other atmospheric contaminants. If the package incorporates copper or some other oxidizable or corrosible metal or alloy, the vulnerable metal must be protected in order to prevent the degradation of the circuitry over time.

Although many possible protective coating materials can be envisioned, the potential number of suitable materials is severely limited by another requirement of the electronic package. It is often the situation that there is physical contact established between one metal or alloy and another. During the package processing steps, such as curing, soldering, and brazing, the structure is often exposed to thermal cycling for prolonged periods of time. Unless the regions of metal-to-metal contact are prevented from interdiffusion during the periods of thermal cycling, the electronic properties of the package will be altered. In particular, interdiffusion between metals will adversely affect the conductivity of the metals. For current-carrying lines of small dimensions, this is a particularly severe problem.

Thus, the current-carrying lines have to be protected against all sorts of chemical attack, including oxidation, and must be protected against interdiffusion with other metals which the current-carrying lines contact. Chemical attack and interduffusion will not only impair the conductivity of the current-carrying lines, but may also adversely affect the adhesion of these lines to an organic dielectric. For example, it is known in the art that polyimides do not adhere well to copper, and consequently an adhesion layer (such as Cr) is used between the copper and the polyimide. The poor adhesion of copper to polyimide may be due to the formation of a loosely adhering copper oxide on the surface of the copper.

These problems are generally known in the art, and reference is made to the following examples of background art:

J. E. Turn and E. L. Owen, "Metallic Diffusion Barriers for the Copper-Electrodeposited Gold System", AES Research Project, Plating, November 1974, at page 1915.

M. R. Pinnel et al, "Mass Diffusion in Polycrystalline . Copper/Electroplated Gold Planar Couples", Metallurgical Transactions, Vol. 3, July 1972, p. 1989.

R. W. Lindsay et al, "The Structure and Mechanical Properties of Electroless Nickel", J. Electrochemical Soc., Vol. 112, No. 4, p. 401, April, 1965. U. S. Patents 4,065,588 and 4,188,438

Flexibility of fabrication is achieved if the coating that provides protection against chemical attack, protection against interdiffusion, and adhesion of the line is capable of electroless deposition. If the protective coating must be electroplated, a plating base would be required which would also require an additional masking step. In addition, protecting a line by plating through a mask would only cover the top of the line; electroless deposition protects all sides. After electroplating, a step to remove the contact layer would be required. Since the current-carrying lines are often extremely small, it is difficult to provide electrical contact to them for electroplating. Even if electrical lands are provided, the IR drop is great with extremely long and small lines, so the amount of current available for plating would be restricted and poor plating would often result. Thus, use of a material capable of electroless plating deposition provides a simpler method of protecting all of the exposed sides of the corrosible line. The use of techniques such as evaporation and sputtering for the deposition of the coating layer is not sufficient, since all three exposed sides of the corrosible material will not be protected.

GB—2,073,778 (Furukawa Circuit Foil Co) discloses the plating of copper foil on one or each side of it with a mixture of nickel and phosphorus prior to attachment of the foil to an insulating support to form a printed circuit board. The phosphorus containing Ni plating layer located between the copper and the insulating support apparently prevents the appearance of brown stains at the foil/substrate interface. These brown stains would otherwise be produced by reaction of the copper with resin at the surface of the substrate during thermal cycling. There is no discussion of the electrical performance of foil treated in this way.

It is desirable to provide a material that offers good protection against chemical attack of underlaying copper or other corrosible lines and, further, the prevents interdiffusion between the copper or other corrosible material and any metal and alloy, such as gold, with which it may be in contact.

It is also desirable to protect copper lines using a coating layer that can be electrolessly deposited.

It is also desirable to provide an improved electronic package that contains organic dielectric material and current carrying metallic lines, where the metallic lines are protected against corrosion.

Accordingly, the present invention provides an electrical structure comprising an insulating substrate overlaid with electrical conductors formed of copper or copper alloy wherein the conductors have a passivating coating comprising cobalt (Co) and phosphorus (P).

The cobalt and phosphorus can be present in many forms, including as a compound or an amorphous mixture, or a mixture of Co and CoP compound. In general, the protective coating includes Co and P, and the P is present in amount at least about 2%, by weight. As an example, 8%P provides a suitable coating in a thickness of approximately 100 nm. Generally, the abbreviation Co/P will be used to designate these various forms.

Co/P can be electroplated or electrolessly plated, although electroless plating is particularly advantageous, as previously pointed out. The use of Co/P as a protective coating has a very important utility in microelectronic structures where the current-carrying lines are very small. For example, a structure of particularly critical importance is one in which a substrate providing mechanical support, such as Si, ceramic, or glass has thereover a layer of thin copper lines, typically having widths of 6—50 micrometres and thicknesses 6—50 micrometers. The copper lines are protected by a coating of Co/P having a thickness of about 50 nm or more. The Co/P has a minimum thickness which will provide a continuous thin film and a maximum thickness normally set by the dimensions required for the electronic package. That is, the protective coating must be continuous and of a thickness to prevent corrosion and interdiffusion (if necessary), and must not be so thick as to substantially alter the sizes required for the current-carrying lines. It is this microelectronic structure which forms a significant part of this invention.

The invention will now be further described with reference to the accompanying drawings, in which:—

Fig. 1 is an end view of a structure representative of the type on which the invention has particular utility, the structure being composed of a microelectronic package including at least one layer of a corrosible conductor which is protected by a layer including Co and P.

Fig. 2 is an end view of a representative structure in which a coating including Co and P is used to protect a corrosible conductor and also to prevent interdiffusion between the conductor and another metal.

Fig. 3 is a plot showing the dependence of the relative resistivity $\rho/\rho_0$ on an annealing cycle, various times and temperatures being shown for an annealed copper line which is uncoated, and an annealed copper line which has a coating of Cr.

Fig. 4 is a plot showing the dependence of the relative resistivity $\rho/\rho_0$ on an annealing cycle of a copper conductor which is protected by a Ni coating. The sample was subjected to the annealing cycle two times.

Fig. 5 is a plot of the dependence of the relative resistivity $\rho/\rho_0$ for two copper conductors, one of which is covered with NiP and the other of which is covered with NiB, during an annealing cycle.

Fig. 6 is a plot showing the dependence of relative resistivity $\rho/\rho_0$ on an annealing cycle for two copper conductors, one of which is protected with a layer of NiP while the other is protected with a layer of NiB, where the compositions of NiP and NiB are different than the composition of the corresponding protective coatings of Fig. 5.

Fig. 7 is a plot of the dependence of relative resistivity $\rho/\rho_0$ of two copper conductors, one of which is protected by a coating of Co, while the other is protected by a coating of Co/P in accordance with the present invention, during an annealing cycle. As is apparent from a comparison of Figs. 3 and 7, the line protected by Co/P has the lowest resistivity at the end of the annealing cycle.

In the practice of this invention it has been discovered that a protective coating including Co and P will provide very effective protection against chemical attack of an underlying corrosible conductor, such as copper, and will also provide an effective interdiffusion barrier between the corrosible conductor and other metal layers which contact the conductor. This protection leads to an improved thin film package in which very thin and narrow conductor lines can be effectively used in a package containing layers of organic dielectric which package has to be heat treated for process steps such as curing, soldering, brazing, etc.

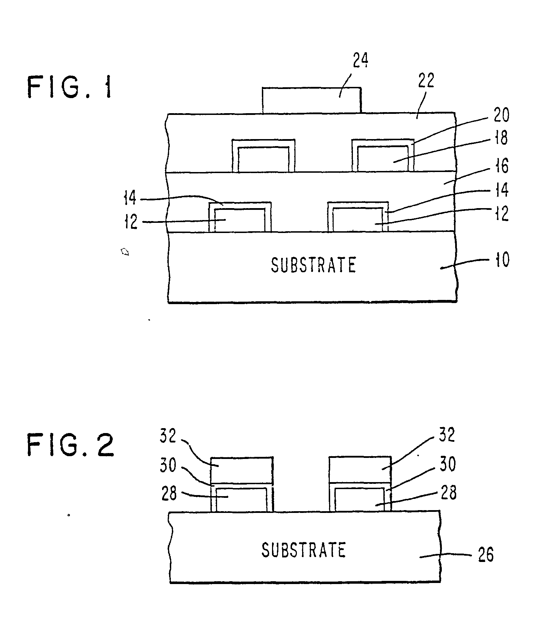

Figs. 1 and 2 represent typical structures in which protection against chemical attack and interdiffusion is required. In Fig. 1, a substrate 10, such as glass, ceramic, silicon, etc., has thereon a first conductive level comprising the conductors 12. These conductors are typically copper, an alloy of copper, or other materials which often contain copper. Conductors 12 are, therefore, composed of corrosible material. For this reason, a thin protective coating layer 14, or cladding, is deposited on the conductors 12. An insulating layer 16, typically an organic dielectric such as polyimide, is deposited over the protected conductors 12. In many multi-layer packages, another layer of corrosible conductors 18 would be provided which are also protected by a protective layer 20 of Co/P. This is followed by the deposition of a second insulating layer 22 which also can be composed of an organic dielectric such as polyimide. Finally, a third conductive layer 24 is provided, which is used for other current-carrying or contact functions in the overall micro-electronic package represented by Fig. 1.

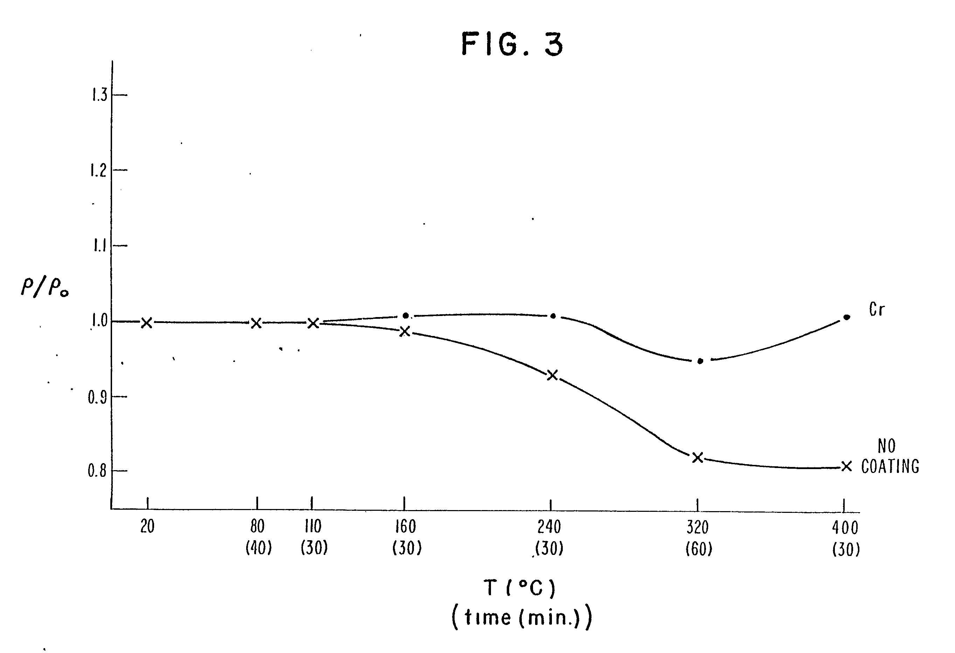

Fig. 2 illustrates a structure in which the Co/P protective layer is also used as an interdiffusion barrier. In Fig. 2, a substrate 26, similar to the substrate 10 of Fig. 1, has a layer of corrosible conductors 28 thereon. Again, these conductors are typically copper or an alloy of copper. A thin protective layer 30 of Co/P is deposited on the conductors 28 and serves to protect them from chemical attack. Protective layer 30 also serves as an interdiffusion barrier between the conductors 28 and an overlying metal layer 32. For example, conductors 28 can be comprised of copper or an alloy of copper, while metal layer 32 can be another conductor such as gold. The Co/P protection layer prevents interdiffusion between conductor 28 and metal layer 32. In contrast with other protective layer compositions, such as those to be described with respect to Figs. 3—7, Co/P provides a very effective interdiffusion barrier between copper and gold. The types of conductors that are protected by the Co/P protective layer include any type of conductor that is more corrosible than Co/P, and is particularly exemplified by conductors comprising copper or alloys of copper. In particular, the invention has for a primary object the protection of conductors which contain copper, the protection being against any type of corrosive attack as well as against interdiffusion with other metals.

The Co/P protective material can take any structural form, including amorphous and crystalline structures. A compound of cobalt and phosphorous is suitable, as well as alloys, mixtures of Co and compounds of Co/P, and mixtures including Co and P. The protective layer has to be pinhole free and continuous in order to provide the protective function, and its thickness is generally that which will provide protection against corrosion and protection against interdiffusion, if the conductor is to be contacted by another metal or any material with which it might interdiffuse. As an example, an alloy comprising 8% phosphorous with the remainder cobalt is particularly suitable at a thickness of about 100 nm. However, thicknesses down to about 50 nm also appear to be suitable, and greater thicknesses than 100 nm can also be used. Depending upon the structure in which the protective Co/P coating is to be used, the upper limit on thickness is quite arbitrary.

The percentage of phosphorous in the coating can be extended over a fairly wide range, and is generally about 2 to about 15%, by weight. These percentages have been found to be particularly useful when the copper is to be protected from corrosion and interdiffusion with other metals, such as gold. In particular, these percentages are particularly suitable for use in multi-layer structures comprising organic dielectrics and copper conductive lines of small dimensions. An advantage of the present invention is that the protective properties of layers containing Co and P are not very sensitive to the amount of P which is present. Generally, at temperatures less than about 400°C, interdiffusion between copper and a contacting metal proceeds by grain boundary diffusion. As the Co/P-clad copper film is heated, $Co_3P$ precipitates in increasing amounts in the grain boundaries, thereby effectively blocking the grain boundary diffusion process. The Co/P protective layer can be electrolessly deposited on the three exposed sides of the conductor lines. In order to initiate electroless deposition on copper, a Pd catalyst is first deposited. A ten second immersion in a room temperature solution of 0.1 g/l Pd $Cl_2$, pH 2 with HCl, followed by a thorough rinse, gives reliable initiation of the electroless process. This treatment will give a Pd coverage on the copper of $<0.5$ µg/cm². This procedure gives good coverage of the copper, but in the plating of patterned copper lines, metal deposition sometimes occurs on the organic dielectric between closely spaced lines (so-called extraneous deposition or bridging). In an effort to reduce this extraneous deposition, a rinse is sometimes used between the Pd activation step and the electroless deposition of Co/P. This rinse is either an aqueous $NH_3$ solution of pH 11.2 or a 0.2 M EDTA solution of pH 7.0 (pH adjusted with NaOH).

A representative solution for electroless deposition of Co/P, 8%P, has the following composition:

| | |
|---|---|
| $CoSO_4 \cdot 7H_2O$ | 35 g/l |
| $NaH_2PO_2 \cdot H_2O$ | 40 g/l |
| Trisodium citrate, dihydrate | 35 g/l |
| $(NH_4)_2SO_4$ | 70 g/l |
| pH (with $NH_3$) | 9.5 |
| Temperature | 85°C |
| Mild Agitation Rate | 2100 Å/min |

References describing the electrodeposition of Co/P alloys are U.S. Patents 3,073,762 and 3,202,590.

Figs. 3—7

These figures are various plots of the resistivity of copper lines, both protected and unprotected, measured as a function of annealing temperature, for different temperature-time intervals of the annealing cycle. In the evaluation of different cladding metals, an increase in resistivity relative to that of the unclad line is an indication of interdiffusion between the two metals. After each temperature-time interval of the anneal, the sample was cooled in vacuum to room temperature, and its sheet resistivity $\rho$ (rho) was measured using a 4-point probe. The resistivity varied from sample to sample because of variations of grain size, density, impurities, etc. For this reason, all results were normalized to the resistivity $\rho_o$ the relative resistivity of the copper line is given by $\rho/\rho_o$, and the horizontal axes of the plots indicates the temperature (°C), while the numbers in parentheses below the temperatures indicate the times in minutes, at that temperature.

Resistance measurements were also used to indicate loss of conducting copper metal by oxidation during curing of polyimide, which is a commonly used organic dielectric in electric and electronic packaging. Some sheet samples were measured with a standard 4-point probe by scraping away some of the polyimide at the center of the sample. Since this scraping procedure may damage copper in the vicinity of the probe and thus adversely affect the resistance measurement, the method of Van der Pauw was used (Philips Res. Repts., 13, 1, 1958) to measure the resistance of the sheet samples. That method involves removal of polyimide to form four arbitrarily placed contacts on the circumference of the sample. Pattern samples were also prepared for 4-point probe measurement of the increase of resistance of a copper line upon polyimide cure.

The interdiffusion between the various protective materials illustrated in Figs. 3—7 and the copper line was studied by submitting examples to a vacuum anneal simulating the temperature excursions encountered in curing polyimide. The samples were annealed in a vacuum of 13 μPa ($10^{-7}$ torr), in order to prevent the effects of interdiffusion of the metals from being confused by the effects due to oxidation.

In order to determine the extent of interdiffusion between copper and the various cladding materials being evaluated, the annealing behavior of copper must first be known. Fig. 3 shows the dependence of the relative resistivity of an unprotected copper film upon annealing. The time the sample remains at each temperature is given in parentheses. The sample consisted of 2.2 mm of electroplated copper on a substrate with an evaporated plating base consisting of 20 nm of Nb and 10 nm of copper. The observed behavior is that expected when the adhesion layer does not diffuse into the copper.

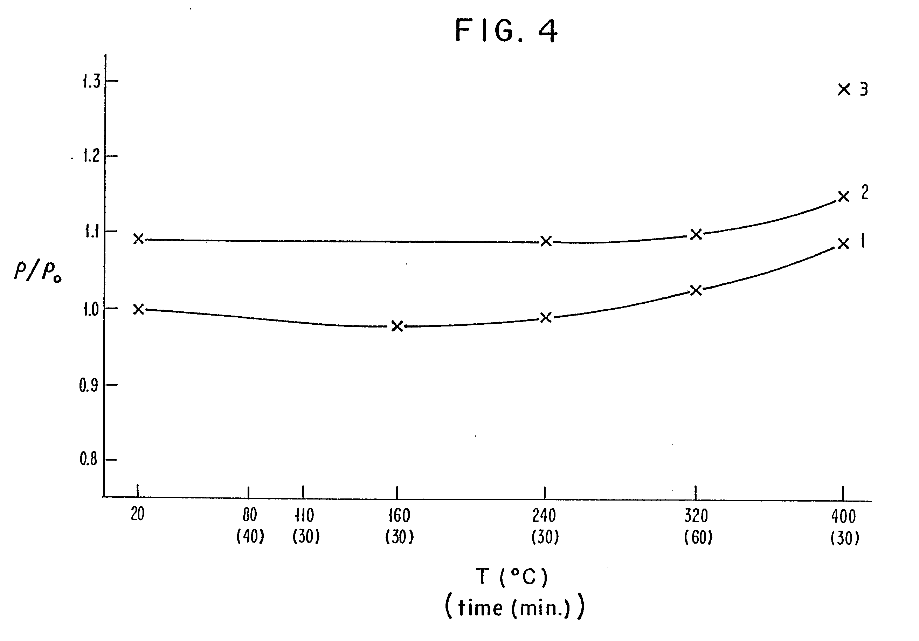

Packaging structures commonly use Cr to give adhesion of copper lines to dielectrics and to protect copper against corrosion. Thus, the materials to be described with respect to Figs. 4—7 should be compared to Cr, which is also illustrated in Fig. 3. Under the conditions of this annealing cycle, the resistivity of Cr-clad copper is always somewhat higher than that of pure copper.

The use of Cr as protection on all exposed sides of a Cu line would entail the use of a complicated process, as has been mentioned earlier. Electrochemical studies of this system indicate that electroless deposition of Cr cannot be achieved without great difficulty, if at all.

Fig. 4 shows the relative resistivity behavior when a layer of Ni of thickness 1000 Å is deposited on copper. The curves are indistinguishable for evaporated and electroplated Ni. After curve 1 was obtained, the annealing cycle was begun again at room temperature to yield curve 2. Further annealing for five hours at 400°C gave point 3. The increase in resistivity of this sample indicates extensive interdiffusion of the copper and nickel, and therefore indicates that nickel is a poor protective coating.

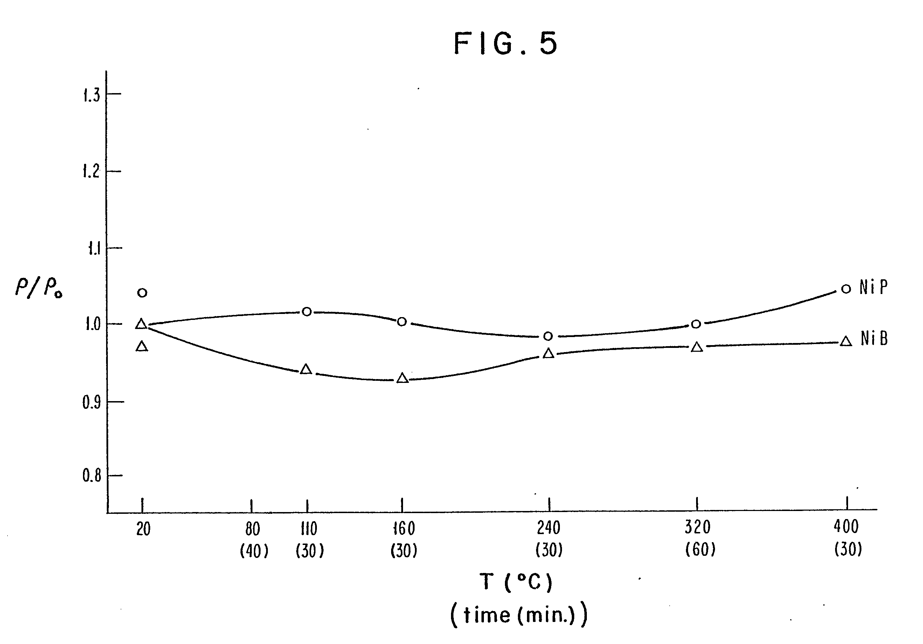

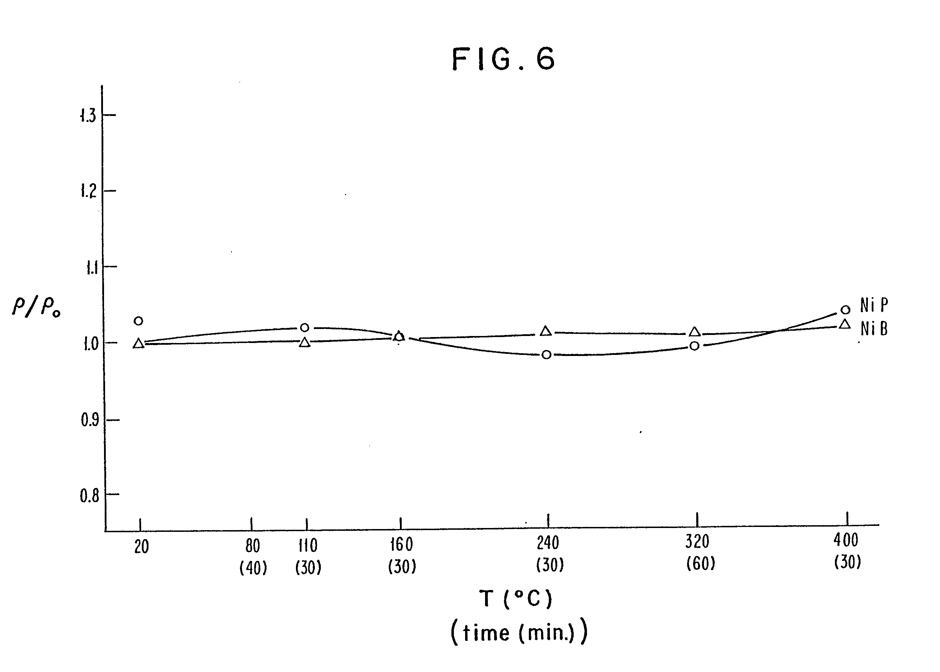

Figs. 5 and 6 illustrate the situation for protective coatings of NiP and NiB which were electrolessly plated. Fig. 6 shows films with higher B and P content than those in Fig. 5. These electroless Ni alloys interdiffuse less extensively with copper than does pure Ni. A clear-cut dependence on P or B concentration was not observed.

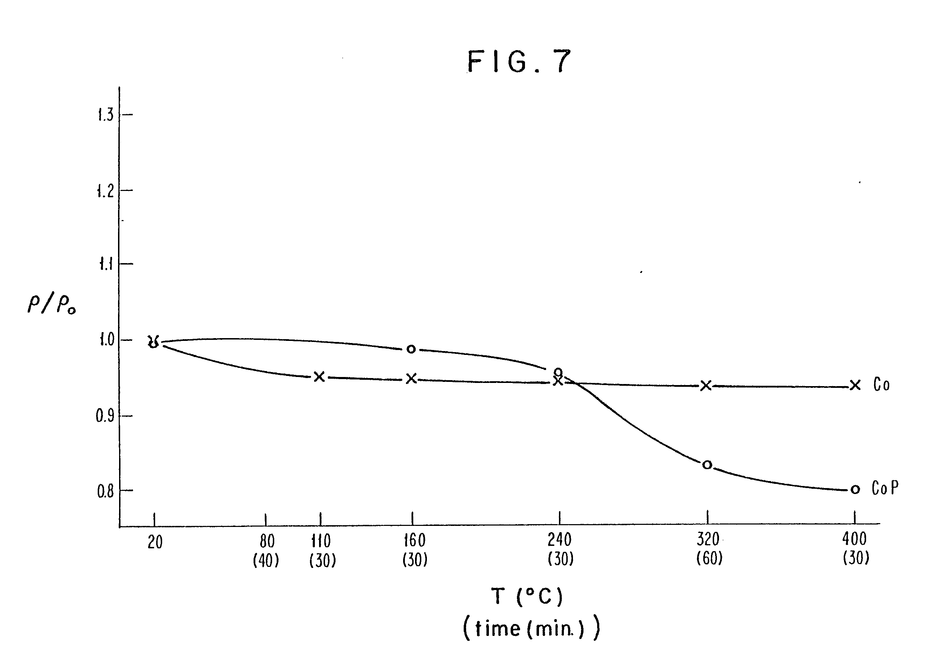

Fig. 7 illustrates the use of a protective layer of Co and a protective layer of Co/P containing 8% P, by weight. Pure Co interdiffuses with copper to a lesser extent than does pure Ni. Fig. 7 shows the best result obtained upon annealing of Co-coated Cu. Cobalt gives less resistivity rise than Cr (Fig. 3). However, alloying of Co with P through electroless deposition leads to even more favorable behavior. As is apparent, the curve for Co/P with 8% by weight P in Fig. 7 is nearly identical to the curve for unprotected Cu in Fig. 3. Since annealing, by itself, will cause a decrease in resistivity of copper (due to effects of crystallinity, etc.), the reference base for the value of the coating is the lower curve in Fig. 3, indicating the behavior of copper in this annealing cycle. As is apparent from a comparison of Figs. 3 and 7, only Co/P provides a protection indicative of substantially no interdiffusion.

In Fig. 7, a second annealing cycle does not result in a rise in resistivity. After an additional four and one half hours at 400°C, the $\rho/\rho_0$ was 0.81. Thus, these annealing studies indicate that Co/P is vastly superior to other protective cladding materials. Co/P was also found to give good bond strength in ultrasonic bonding of Au-coated CdCu wires.

In the practice of this invention films containing Co and P were found to provide vastly superior protection of corrosible conductors, especially those having copper therein. This protection was observed even during harsh annealing cycles, such as those used to provide electronic packages.

## Claims

1. An electrical structure comprising an insulating substrate (10; 26) overlaid with electrical conductors (12, 18; 28) formed of copper or copper alloy, wherein the conductors have a passivating coating (14, 20; 30) comprising cobalt (Co) and phosphorus (P).

2. A structure as in claim 1 in which the passivating coating is present only on conductor sides which are not in contact with the substrate.

3. A structure as in claim 1 or claim 2 further comprising a dielectric layer (16, 22) overlying the electrical conductors, the passivating coating being interposed between the conductors and the dielectric layer and substantially preventing corrosion of the electrical conductors during thermal cycling of the structure.

4. A structure as in any preceding claim further comprising further electrical conductors (32) in direct contact with the passivating coating (30), the passivating coating substantially preventing interdiffusion between said electrical conductors and said further electrical conductors.

5. A structure as claimed in claim 4 in which the material of said further electrical conductors is gold.

6. A structure as in any preceding claim in which the material of the dielectric layer is polyimide.

7. A structure as in any preceding claim in which P comprises between 2% and 15% by weight of the passivating coating.

8. A structure as claimed in claim 7 in which P comprises 8% by weight of the passivating coating.

9. A structure as in any preceding claim in which the passivating coating has a thickness of at least 50 nanometres.

10. A structure as in any preceding claim in which the passivating coating is electrolessly deposited.

## Patentansprüche

1. Elektrischer Aufbau mit einem isolierenden Substrat (10; 26), welches mit aus Kupfer oder eine Kupferlegierung ausgebildeten elektrischen Leitern (12, 18; 28) belegt ist, wobei die Leiter einen Passivierungsüberzug (14, 20; 30) aufweisen, welcher Kobalt (Co) und Phosphor (P) umfaßt.

2. Aufbau nach Anspruch 1, bei welchem der Passivierungsüberzug nur auf Leiterseiten vorhanden ist, die nicht mit dem Substrat in Berührung stehen.

3. Aufbau nach Anspruch 1 oder 2, welcher ferner eine über den elektrischen Leitern leigende dielektrische Schicht (16, 22) aufweist, wobei der Passivierungsüberzug zwischen den Leitern und der dielektrischen Schicht liegt und wesentlich eine Korrosion der elektrischen Leiter verhindert, während der Aufbau durch einen thermischen Zyklus geführt wird.

4. Aufbau nach irgendeinem der vorstehenden Ansprüche, welcher ferner weitere elektrische Leiter (32) in direkter Berührung mit dem Passivierungsüberzug (30) umfaßt, wobei der Passivierungsüberzug im wesentlichen eine Interdiffusion zwischen den elektrischen Leitern und den weiteren elektrischen Leitern verhindert.

5. Aufbau nach Anspruch 4, bei welchem das Material der weiteren elektrischen Leiter Gold ist.

6. Aufbau nach irgendeinem vorstehenden Anspruch, bei welchem das Material der dielektrischen Schicht Polyimid ist.

7. Aufbau nach irgendeinem vorstehenden Anspruch, bei welchem P zwischen 2 Gew.-% und 15 Gew.-% des Passivierungsüberzuges ausmacht.

8. Aufbau nach Anspruch 7, bei welchem P 8 Gew.-% des Passivierungsüberzuges ausmacht.

9. Aufbau nach irgendeinem vorstehenden Anspruch, bei welchem der Passivierungsüberzug eine Dicke von wenigstens 50 Nanometern hat.

10. Aufbau nach irgendeinem vorstehenden Anspruch, bei welchem der Passivierungsüberzug stromlos abgeschieden ist.

## Revendications

1. Structure électrique comportant un substrat isolant (10; 26) recouvert de conducteurs électriques (12, 18; 28) faits en cuivre ou en alliage de cuivre, dans lequel les conducteurs portent un revêtement de passivation (14, 20; 30) comprenant du cobalt (Co) et du phosphore (P).

2. Structure selon la revendication 1, dans laquelle le revêtement de passivation n'est présent que sur les côtés des conducteurs qui ne sont pas en contact avec le substrat.

3. Structure selon la revendication 1 ou la revendication 2, comportant en outre une couche diélectrique (16, 22) recouvrant les conducteurs électriques, le revêtement de passivation étant intercalé entre les conducteurs et la couche diélectrique et évitant pratiquement la corrosion des conducteurs électriques pendant les cycles thermiques de la structure.

4. Structure selon l'une quelconque des revendications précédentes, comportant en outre d'autres conducteurs électriques (32) en contact direct avec le revêtement de passivation (30), le revêtement de passivation évitant pratiquement toute diffusion mutuelle entre lesdits conducteurs électriques et lesdits autres conducteurs électriques.

5. Structure selon la revendication 4, dans laquelle la matière des autres conducteurs électriques est de l'or.

6. Structure selon l'une quelconque des revendications précédentes, dans laquelle la matière de la couche diélectrique est du polyimide.

7. Structure selon l'une quelconque des revendications précédentes, dans laquelle le phosphore représente entre 2% et 15% en poids du revêtement de passivation.

8. Structure selon la revendication 7, dans laquelle le phosphore représente 8% en poids du revêtement de passivation.

9. Structure selon l'une quelconque des revendications précédentes, dans laquelle le revêtement de passivation a une épaisseur d'au moins 50 nanométres.

10. Structure selon l'une quelconque des revendications précédentes, dans laquelle le revêtement de passivation est déposé par voie non électrolytique.

FIG. 1

FIG. 2

# FIG. 3

EP 0 130 468 B1

# FIG. 4

FIG. 5

EP 0 130 468 B1

FIG. 6

○ Ni P
△ Ni B

$\rho/\rho_o$

T (°C)
(time (min.))

FIG. 7

EP 0 130 468 B1